# EUROPÄISCHE PATENTANMELDUNG

(11) **EP 4 528 291 A1**
(43) Veröffentlichungstag der Anmeldung: **26.03.2025**
(21) Anmeldenummer: 23198314.9
(22) Anmeldetag: 19.09.2023
(51) Int. Cl.: G01R 1/20, G01R 1/30, G01R 19/00

(54) **LEISTUNGSHALBLEITERMODUL MIT STÖRUNEMPFINDLICHER MESSUNG SEINER SHUNTSPANNUNG**

(71) Anmelder: Siemens Aktiengesellschaft, 80333 München (DE)
(72) Erfinder: Hensler, Alexander, 91466 Gerhardshofen (DE)
(74) Vertreter: Siemens Patent Attorneys

(57) **Zusammenfassung**

Die Erfindung betrifft ein Leistungshalbleitermodul mit einem Leistungsstrompfad (17) in dem ein Shuntwiderstand (1), insbesondere ein Widerstand ≤50mOhm angeordnet ist,
wobei der Shuntwiderstand (1) zwei voneinander beabstandete Hauptmesskontakte (2,3) unterschiedlicher Polarität (+,-) aufweist und ein Hilfsmesskontakt (4) in unmittelbarer Nähe des Shuntwiderstandes (1) angeordnet ist, ohne mit diesem in direkter elektrischen Verbindung zu sein,
wobei von jedem Messkontakt (2,3,4) eine Messleitung (20,21,22) zu einer Auswerteeinheit (6) führt und dabei nahezu flächenmäßig identische Schleifen (18,19) bildet

## Beschreibung

Die Erfindung betrifft ein Leistungshalbleitermodul mit störunempfindlicher Messung seiner Shuntspannung, als auch ein Verfahren einer störunempfindlichen Messung einer Shuntspannung bei einem Leistungshalbleitermodul.

Durch die zunehmende Anforderung an immer höhere Leistungsdichten der Leistungselektronik wird die Strommessung bei Umrichtern mit Hilfe kompakter Shuntwiderstände realisiert, die im Leistungshalbleitermodul integriert sind.

Dabei werden die Shuntwiderstände innerhalb des Leistungshalbleitermoduls sehr nah an den Leistungshalbleitern positioniert. Diese Nähe bedingt Störeinkopplungen, auf die zum Shuntwiderstand führenden Messleitungen, was zu Fehlmessungen führt.

Eine effektive bekannte Lösung gegen diese Störeinkopplung ist eine verdrillte Leitung. Diese Lösung kann bei der Herstellung von Leistungshalbleitermodulen nur manuell umgesetzt werden. Automatisierte Fertigung dieser Lösung ist sehr aufwändig. Außerdem verbleibt eine parallele Leitungsführung an den Pins des Leistungsmoduls. Dieser Bereich bleibt trotz verdrillter Leitungen somit weiter als Fenster für Störeinkopplung.

Eine andere Lösung, um diese Störeinkopplungen zu reduzieren, ist die Vergrößerung des Nutzsignals. Bei den Shuntwiderständen führt dies jedoch zu einer Vergrößerung des Widerstandswertes. Dadurch verringert sich das Verhältnis von Störung zum Messsignal.

Bisher bekannte und gängige Analog-Digital-Wandler weisen einen Messbereich von 50mV oder 200mV auf. Die Shunt-Auslegung für den 50mV-Messbereich führt aufgrund des niedrigen Spannungsabfalls zu einer vergleichsweise hohen Störeinkopplung.

Eine Änderung auf den höheren, insbesondere 200mV Messbereich, bedeutet jedoch eine Vervielfachung, insbesondere Vervierfachung des ohmschen Widerstandes des Shunts. Dadurch erhöht sich auch die Verlustleistung, insbesondere um den Faktor vier. Um diese Verluste abführen zu können, muss eine Parallelschaltung der Shuntwiderstände gewählt werden. Dies erhöht jedoch Kosten und Platzbedarf in einem Leistungshalbleitermodul.

Ausgehend davon liegt deshalb der Erfindung die Aufgabe zugrunde, ein kompaktes Leistungshalbleitermodul mit störunempfindlicher Messung bereitzustellen.

Die Lösung der gestellten Aufgabe gelingt durch die Merkmale der unabhängigen Ansprüche.

Vorteilhafte Ausgestaltungen sind den abhängigen Ansprüchen zu entnehmen.

Erfindungsgemäß wird also bei einem Leistungshalbleitermodul mit einem Leistungsstrompfad in dem ein Shuntwiderstand, insbesondere ein Widerstand ≤50mOhm angeordnet ist eine störunempfindliche Stromerfassung ermöglicht. Dabei sind zwei voneinander beabstandete Hauptmesskontakte unterschiedlicher Polarität (+,-)und ein Hilfsmesskontakt in unmittelbarer Nähe des Shuntwiderstandes vorhanden, wobei der Hilfsmesskontakt mit dem Shuntwiderstand nicht in direkter elektrischen Verbindung steht. Durch diese Anordnung wird eine störunempfindliche Stromerfassung am Shuntwiderstand ermöglicht, indem von jedem Messkontakt - sowohl Hauptmesskontakt als auch Hilfsmesskontakt - eine Messleitung zu einer Auswerteeinheit führt und dabei nahezu flächenmäßig identische Schleifen bildet.

Dabei sind Leistungshalbleiter Halbleiterbauelemente, die in der Leistungselektronik für das Steuern und Schalten hoher elektrischer Ströme und Spannungen ausgelegt sind (mehr als 1 Ampere und Spannungen von mehr als etwa 24 Volt). Die Obergrenze dieser Größen sind dabei jeweils mehrere Tausend Ampere und Volt.

Dazu werden angepasste Varianten normaler Halbleiterbauelemente eingesetzt, da hohe Ströme und Spannungen diese zerstören würden. Eingesetzt werden vorzugsweise folgende Bauelemente:
Leistungsdioden, (sind Schaltelemente, die den Strom prinzipiell nur in einer Richtung oder nur oberhalb eines bestimmten Spannungswertes durchfließen lassen),
Thyristoren,
GTO("Gate-Turn-Off" oder SCR, "Silicon-Controlled-Rectifier" sind Schaltelemente, die den Schaltpunkt durch eine steuerbare Spannung an einer Steuerelektrode beliebig und flexibel einstellen lassen),
Triacs, (sind zwei Thyristorelemente in einem Bauteil, die gegenläufig parallelgeschaltet sind und gemeinsam gesteuert werden) und
Leistungs-MOSFETs und IGBT-Bauteile (sind Transistoren mit besonderen Schalt- und Leistungseigenschaften aufgrund ihrer atomaren Halbleiterstruktur).

Die Leistungshalbleiter werden dabei elektrisch leitend mit den Leistungskontakten des jeweiligen Leistungshalbleitermoduls verbunden sind.

Erfindungsgemäß wird als Shuntwiderstand ein Strommesswiderstand bezeichnet, also ein niederohmiger elektrischer Messwiderstand, vielfach ausgestattet mit getrennten Strom- und Spannungsklemmen. Dieser wird unmittelbar in die stromführende Leitung, also den Leistungsstrompfad des Leistungshalbleiters eingefügt. Durch die zu dieser Art von Shuntwiderstand parallelgeschalteten Auswerteeinheit wird damit nur ein vergleichsweise kleiner Strom abgeleitet und die daran "abfallende" Spannung erfasst.

Bei großen Stromstärken, z.B. größer 10A, wird dabei die Strommessung über eine Messung der elektrischen Spannung an einem Shunt ausgeführt. Zur Messung sehr hoher Ströme (>100A) sind die Shuntwiderstände mechanisch robust aufgebaut, beispielsweise aus Metallbändern oder -stäben mit kräftigen Schraubkontakten für den Last-Stromkreis (Verbraucherkreis) und zwei kleineren Messkontakten für den Anschluss z.B. eines Messgerätes. Große Shuntwiderstände aus parallelen Metallstäben können auch direkt zwischen Stromschienen geschraubt werden. Materialien für derartige Shuntwiderstände sind beispielsweise Manganin, Isotan, Isabellin, die sich durch einen geringen Temperaturkoeffizienten des spezifischen elektrischen Widerstandes und eine kleine Thermospannung gegen Kupfer auszeichnen. Dabei ist auf eine ausreichende Wärmeabfuhr zu achten.

Diese Shunts sind oft ausgelegt auf eine Spannung von 50mV oder 200mV beim Nennwert der Stromstärke im Leistungspfad. Die Stromstärke im Shunt wird nach dem ohmschen Gesetz berechnet.

Der Shuntwiderstand wird in die Leitung des zu messenden Stromes eingebaut. Der durch diesen Widerstand entstehende Spannungsabfall wird gemessen. Die Übergangswiderstände in den Stromklemmen sind oft größer als der Messwiderstand, dabei quantitativ unbekannt.

Da in der Leistungselektronik und bei Umrichtern auch Stromstärken mit kurzen Anstiegszeiten oder hohen Frequenzen gemessen werden sollen, sind die Shuntwiderstände, insbesondere mit geringer parasitärer Induktivität, ausgeführt. Axiale oder axial gewickelte Widerstände sind dabei nur bedingt einsetzbar. Besser geeignet für derartige Shuntwiderstände sind bifilar gewickelte Widerstände oder spezielle Bauformen, wie ein koaxialer Shunt, der aus zwei ineinander gesteckten Röhren besteht, die in entgegengesetzter Richtung vom Strom durchflossen werden. Weitere niederinduktive Bauformen sind bekanntermaßen der Möbius-Widerstand oder wellenförmige Widerstandsfolien.

Shuntwiderstände sind eine preiswerte und genaue Methode der Strommessung und werden grundsätzlich, außer in Messgeräten, auch in Leistungselektronik-Baugruppen zur Stromüberwachung und -regelung eingesetzt.

Ein derartiges Leistungshalbleitermodul wird bei Stromrichter eingebaut. Unter einem Stromrichter ist beispielsweise ein Gleichrichter, ein Wechselrichter, ein Umrichter oder ein Gleichspannungswandler zu verstehen.

Erfindungsgemäß wird direkt unmittelbar am Shuntwiderstand, insbesondere mittels einer Brücke, ein Hilfsmesskontakt geschaffen, der auf dem gleichen Potential wie ein zweiter Messkontakt liegt.

Durch die abwechselnde Anordnung der Messsignale (-+-, oder alternativ: +-+), ergibt sich eine Möglichkeit die Messung des Spannungsabfalls störunempfindlich zu gestalten.

Dabei verlaufen drei Messleitungen vom Shuntwiderstand zur Auswerteeinheit derart, dass gleich große Schleifen gebildet werden, insbesondere verlaufen die Messleitungen parallel und möglichst eng nebeneinander. Durch die Anordnung bei der die zwei Hauptmesskontakte auf unterschiedlichem Potential und der Hilfsmesskontakt auf dem Potential des zweiten Hauptmesskontaktes liegt, also entweder "+" oder alternativ "-" bilden sich zwischen den nunmehr drei Messleitungen flächenmäßig gleich große Schleifen, über die ein Störfeld in diese Messleitungen einkoppelt.

Diese Störeinkopplung lässt sich bisher, wie oben beschrieben, reduzieren, aber nicht ohne weiteres verhindern.

Erfindungsgemäß lässt man also explizit zunächst eine Störeinkopplung zu.

Diese Störeinkopplung (dB/dt) erfolgt vorzugsweise in jeweils einer von den Schleifen ausgespannten Ebene. Dieses Störsignal induziert in den durch die Messleitungen gebildeten Leiterschleifen ein elektrisches Feld (dE/dt) und verursacht an den Eingängen der Auswerteeinheit eine Störspannung mit unterschiedlichem Richtungssinn.

In einem Operationsverstärker der Auswerteeinheit vergrößert die Störung das eigentliche Messsignal, während im anderen Operationsverstärker dieser Auswerteinheit die Störung entgegengesetzt zum Messsignal wirkt.

Durch eine nachfolgende analoge Summenbildung beider Signale, z.B. mittels einer Widerstandsschaltung, löscht sich das Störsignal vor Eintritt in einen A/D-Wandler aus.

Durch starke Gradienten des Störfeldes können die Störspannungen in den beiden Schleifen unterschiedlich groß induziert werden. Dieser Effekt kann zusätzlich durch eine möglichst enge parallele Leitungsführung der Messleitungen vermieden werden oder zumindest deutlich herabgesenkt werden.

Mit der vorgeschlagenen Lösung können somit weiterhin kleine Spannungssignale der Shuntwiderstände störunempfindlich gemessen werden. Damit ist die Verwendung verhältnismäßig kleiner Widerstände, insbesondere ≤50mOhm für den 50mV-Messbereich des A/D-Wandlers, möglich.

Die in Bezug auf den Leistungshalbleiter nachstehend angeführten Vorteile und bevorzugten Ausgestaltungen lassen sich sinngemäß auf das Verfahren zur störunempfindlichen Strommessung übertragen.

Erfindungsgemäß stellen sich dadurch folgende Vorteile ein: Es sind schnellere Strommessungen am Leistungshalbleitermodul möglich, da die Filter-Grenzfrequenz eines Anti-Aliasing-Filters erhöht werden kann. Des Weiteren tritt eine Einsparung der Shuntwiderstände durch Verwendung des 50mV Spannungsmessbereichs ein. Durch den kompakten Aufbau der Strommessung reduziert sich die dafür notwendige Bestückungsfläche im Leistungshalbleitermodul. Durch den erfindungsgemäßen Aufbau und das Verfahren verringert sich die Verlustleistung u.a. innerhalb des Leistungshalbleitermoduls. Ein derartiger Aufbau lässt sich vorteilhafterwiese gegenüber den bisherigen Aufbauten automatisiert herstellen.

Die Erfindung sowie weitere vorteilhafte Ausgestaltungen der Erfindung werden anhand prinzipiell dargestellter Ausführungsbeispiele näher erläutert, darin zeigen:
- FIG 1: prinzipieller Aufbau und Anordnung des Shuntwiderstandes,
- FIG 2: Wirkungsweise des Messverfahrens,
- FIG 3: Signalverlauf.

Der Übersichtlichkeit wegen werden in den Figuren teilweise in den Fällen, in denen Bauteile mehrfach vorhanden sind, häufig nicht sämtliche dargestellten Bauteile mit Bezugszeichen versehen.

Die beschriebenen Ausführungen können beliebig kombiniert werden. Ebenso sind auch Einzelmerkmale der jeweiligen Ausführungen kombinierbar, ohne das Wesen der Erfindung zu verlassen.

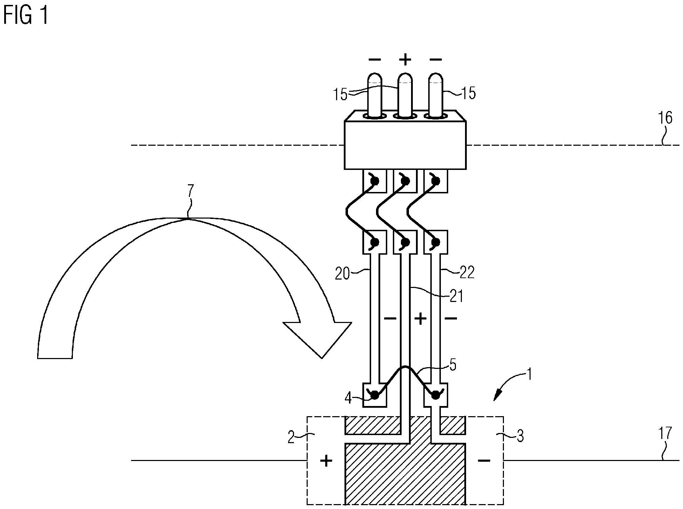

FIG 1 zeigt einen Shuntwiderstand 1, der in einem Leistungsstrompfad eines Leistungshalbleiters angeordnet ist. Direkt am Shuntwiderstand 1 wird insbesondere mittels einer Brücke 5 ein Hilfsmesskontakt 4 gebildet - also ein dritter Anschluss - neben den beiden Hauptmesskontakten, dem ersten Hauptmesskontrakt 2 und dem zweiten Hauptmesskontakt 3. Der Hilfsmesskontakt 4 liegt auf dem gleichen Potential wie der zweite Hauptmesskontakt 3.

Durch die abwechselnde Anordnung der Messsignale (-+-, oder alternativ: +-+), ergibt sich eine Möglichkeit, die Messung des Spannungsabfalls am Shuntwiderstand 1 störunempfindlich zu gestalten.

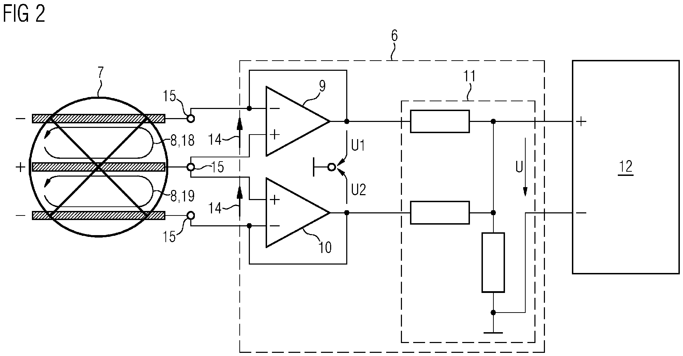

Erfindungsgemäß verlaufen drei Messleitungen 20, 21, 22 parallel und eng nebeneinander. Durch die Anordnung -+- (oder alternativ +-+) bilden sich gleich große Schleifen 18, 19 (siehe auch FIG 2), über die ein Störsignal 7 in diese Messleitungen 20, 21, 22 einkoppelt.

Diese Störeinkopplung (dB/dt) erfolgt gemäß FIG 2 in die Ebene. Dieses Störsignal 7 induziert in den Schleifen 18, 19 ein elektrisches Feld 8 (dE/dt) und verursacht ein Störsignal 14, insbesondere eine Störspannung an den Eingängen einer Auswerteeinheit 6, die sich vorzugsweise direkt an den Pins 15 eines Gehäuses 16 des Leistungshalbleitermoduls befinden. In dieser Auswerteinheit 6 sind die Operationsverstärker 9, 10 angeordnet, denen diese Messsignale gemäß FIG 2 zugeführt werden.

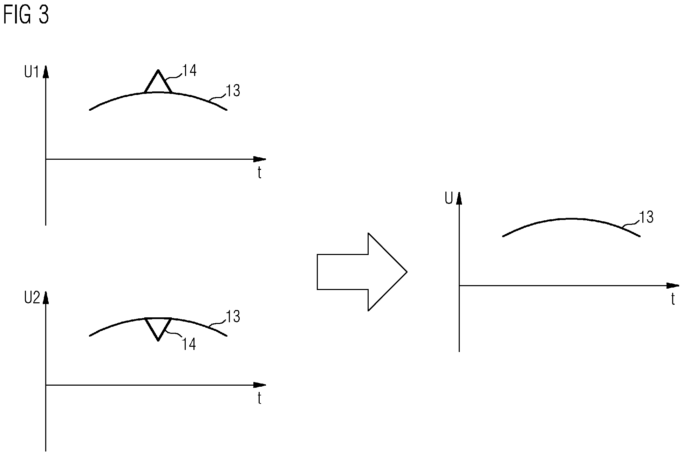

Im ersten Operationsverstärker 9 vergrößert das Störsignal 7 das Nutzsignal 13, während im zweiten Operationsverstärker 10 die Störung entgegengesetzt zum Nutzsignal 13 wirkt. Durch die den Operationsverstärkern 9, 10 nachgeschaltete analoge Summenbildung, insbesondere durch eine Widerstandsschaltung 11 beider Signale, löscht sich das Störsignal 7 (siehe FIG 3) aus.

Durch starke Gradienten des Störfeldes können die Störspannungen in den beiden Schleifen 18, 19 mit unterschiedlichen Werten induziert werden. Dieser Effekt kann durch besonders enge parallele Leitungsführung der Messleitungen 20, 21, 22 vermieden werden oder zumindest deutlich herabgesenkt werden. Wichtig ist, dass die aufgespannten Flächen der Schleifen 18, 19 möglichst identisch sind, um das betragsmäßig gleiche Signal 14 zu erhalten.

Mit der vorgeschlagenen Lösung können somit auch kleine Spannungssignale der Shuntwiderstände 1 störunempfindlich gemessen werden. Damit ist konkret die Verwendung kleiner Shuntwiderstände 1 für den 50mV-Messbereich des A/D-Wandlers 12 möglich.

Folgende Vorteile ergeben sich durch das Leistungshalbleitermodul dem Shuntwiderstand 1 und das Verfahren zur Messung des Stromes im Leistungsstrompfad 17:
- Es ist erfindungsgemäß nunmehr eine vergleichsweise schnelle Strommessung möglich, da die Filter-Grenzfrequenz eines Anti-Aliasing-Filters erhöht werden kann von ca. <100kHz auf ≥300kHz.
- Die Varianz von Shuntwiderständen 1 kann reduziert werden, insofern liegt eine Einsparung der Shuntwiderständen 1 durch den 50mV Spannungsmessbereich vor.
- Die erforderliche Bestückungsfläche im Leistungshalbleitermodul kann reduziert werden, was einem kompakteren Aufbau zugutekommt.
- Der erfindungsgemäße Aufbau führt zu einer Verringerung der Verlustleistung, insbesondere am Shuntwiderstand 1.
- Der erfindungsgemäße Aufbau gestattet außerdem zumindest in diesem Bereich des Leistungshalbleitermoduls eine automatisierte Fertigung.

## Patentansprüche

1. Leistungshalbleitermodul mit einem Leistungsstrompfad (17) in dem ein Shuntwiderstand (1), insbesondere ein Widerstand ≤50mOhm angeordnet ist,
wobei der Shuntwiderstand (1) zwei voneinander beabstandete Hauptmesskontakte (2,3) unterschiedlicher Polarität (+,-) aufweist und ein Hilfsmesskontakt (4) in unmittelbarer Nähe des Shuntwiderstandes (1) angeordnet ist, ohne mit diesem in direkter elektrischer Verbindung zu sein,
wobei von jedem Messkontakt (2,3,4) eine Messleitung (20,21,22) zu einer Auswerteeinheit (6) führt und dabei nahezu flächenmäßig identische Schleifen (18,19) bildet.

2. Leistungshalbleitermodul mit einem Leistungsstrompfad (17) nach Anspruch 1, **dadurch gekennzeichnet, dass** der Abstand Hilfskontakt (4) zu erstem Hauptmesskontakt (2) gleich groß ist wie der Abstand zwischen erstem Hauptmesskontakt (2) und zweitem Hauptmesskontakt (3).

3. Leistungshalbleitermodul mit einem Leistungsstrompfad (17) nach Anspruch 1 oder 2, **dadurch gekennzeichnet, dass** Hilfsmesskontakt (4) mittels einer elektrischen Brücke (5) vom zweiten Hauptmesskontakt (3) gebildet ist.

4. Leistungshalbleitermodul mit einem Leistungsstrompfad (17) nach einem der vorhergehenden Ansprüche, **dadurch gekennzeichnet, dass** die Messleitungen (20, 21,22) im Wesentlichen in einer Ebene verlaufen.

5. Leistungshalbleitermodul mit einem Leistungsstrompfad (17) nach einem der vorhergehenden Ansprüche, **dadurch gekennzeichnet, dass** die Messleitungen (20, 21,22) zur Auswerteeinheit (6) parallel und aneinanderliegend verlegt sind.

6. Leistungshalbleitermodul mit einem Leistungsstrompfad (17) nach einem der vorhergehenden Ansprüche, **dadurch gekennzeichnet, dass** die Auswerteeinheit (6) zumindest zwei Operationsverstärker (9,10) und eine Summationsschaltung aufweist.

7. Stromrichter einer Antriebseinheit, mit zumindest einem Leistungshalbleitermodul nach einem der vorhergehenden Ansprüche 1 bis 6.

8. Verfahren zur störunempfindlichen Stromerfassung in einem Leistungshalbleitermodul mit einem Leistungsstrompfad (17) in dem ein Shuntwiderstand (1), insbesondere ein Widerstand ≤50mOhm angeordnet ist,
wobei der Shuntwiderstand (1) zwei voneinander beabstandete Hauptmesskontakte (2,3) unterschiedlicher Polarität (+,-) aufweist und ein Hilfsmesskontakt (4) in unmittelbarer Nähe des Shuntwiderstandes (1) angeordnet ist, ohne mit diesem in direkter elektrischer Verbindung zu sein,
wobei von jedem Messkontakt (2,3,4) eine Messleitung (20, 21,22) zu einer Auswerteeinheit (6) führt und dabei nahezu flächenmäßig identische Schleifen (18,19) bildet,
durch folgende Schritte:
- Erfassung der Messsignale an den Messkontakten (2,3,4),
- die Messsignale werden über Messleitungen (20,21,22) einer Auswerteeinheit (6) bereitgestellt,
- innerhalb der Auswerteeinheit (6) wird über Operationsverstärker (9, 10) und analoger Summenbildung der beiden Ausgänge der Operationsverstärker (9,10), insbesondere mittels einer Widerstandsschaltung ein bereinigtes Messsignal (Nutzsignal) generiert, das einem A/D-Wandler (12) zur weiteren Verarbeitung in einer Regelung, insbesondere Antriebsregelung zugeführt wird.
